(19) **Europäisches Patentamt / European Patent Office / Office européen des brevets**

(11) **EP 4 357 854 A1**

(12) **EUROPEAN PATENT APPLICATION**

(43) Date of publication:
**24.04.2024   Bulletin 2024/17**

(21) Application number: **22202732.8**

(22) Date of filing: **20.10.2022**

(51) International Patent Classification (IPC):
**G03F 7/20** (2006.01)       **G03F 9/00** (2006.01)
**H01L 21/66** (2006.01)

(52) Cooperative Patent Classification (CPC):
**G03F 7/705; G03F 7/70508; G03F 7/70525;
G03F 7/70616; G03F 7/70633; G03F 9/7092;
H01L 22/20;** H01L 22/12

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **ROY, Sarathi**
  **5500 AH Veldhoven (NL)**
• **WERKMAN, Roy**
  **5500 AH Veldhoven (NL)**
• **MANNEKE, Daan**
  **5500 AH Veldhoven (NL)**

(74) Representative: **ASML Netherlands B.V.
Corporate Intellectual Property
P.O. Box 324
5500 AH Veldhoven (NL)**

(54) **METHOD OF PREDICTING A PARAMETER OF INTEREST IN A SEMICONDUCTOR MANUFACTURING PROCESS**

(57)     Described is a method for predicting a parameter of interest of a manufacturing process for manufacturing integrated circuits. The method comprises: obtaining metrology data relating to the parameter of interest; applying a first prediction sub-module to said metrology data to obtain non-anomalous prediction data; detecting anomalies in said metrology data (e.g., using an anomaly detection module); dividing said anomalies into systematic anomalies and non-systematic anomalies; using a first prediction strategy on said non-systematic anomalies to obtain first anomaly prediction data; using a second prediction strategy on said systematic anomalies to obtain second anomaly prediction data; wherein said first prediction strategy is different to said second prediction strategy; and combining said first anomaly prediction data and/or second anomaly prediction data with said non-anomalous prediction data to obtain a prediction of the parameter of interest.

Fig. 7

**Description**

FIELD

The present invention relates to semiconductor manufacturing processes, in particular to methods of inspection or metrology in a semiconductor manufacturing process.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

These tight control loops are generally based on metrology data obtained using a metrology tool measuring characteristics of the applied pattern or of metrology targets representing the applied pattern. In general the metrology tool is based on optical measurement of the position and/or dimensions of the pattern and/or targets. It is intrinsically assumed that these optical measurements are representative for a quality of the process of manufacturing of the integrated circuits.

A process correction for an IC manufacturing process may be determined from metrology data of previously exposed wafers (the term wafer and substrate are used interchangeably and/or synonymously throughout this disclosure), so as to minimize any error in the metrology data of subsequently exposed wafers. However, it can be sometimes difficult to interpret the metrology data, i.e., the metrology data is not always representative of the best correction.

SUMMARY

It is an object of the inventors to address the mentioned disadvantage of the state of the art.

In a first aspect of the invention there is provided a method for predicting a parameter of interest of a manufacturing process for manufacturing integrated circuits, the method comprising: obtaining metrology data relating to the parameter of interest; applying a first prediction sub-module to said metrology data to obtain non-anomalous prediction data; detecting anomalies in said metrology data (e.g., using an anomaly detection module); dividing said anomalies into systematic anomalies and non-systematic anomalies; using a first prediction strategy on said non-systematic anomalies to obtain first anomaly prediction data; using a second prediction strategy on said systematic anomalies to obtain second anomaly prediction data; wherein said first prediction strategy is different to said second prediction strategy; and combining said first anomaly prediction data and/or second anomaly prediction data with said non-anomalous prediction data to obtain a prediction of the parameter of interest.

Also disclosed is a computer program and various apparatuses operable to perform the method of the first aspect.

BRIEF DESCRIPTION OF THE DRAWINGS

Embodiments of the invention will now be described, by way of example only, with reference to the accompanying schematic drawings, in which:

Figure 1 depicts a schematic overview of a lithographic apparatus;
Figure 2 depicts a schematic overview of a lithographic cell;
Figure 3 depicts a schematic representation of holistic lithography, representing cooperation between three key technologies to optimize semiconductor manufacturing; and

Figure 4a and 4b illustrate schematically two known feedback control methods applied in a manufacturing facility.

Figure 5 is a simplified schematic flow diagram of part of an IC manufacturing method according to a known method;

Figure 6 is a plot of a control parameter value PV (or a metrology parameter value dependent on the control parameter) against time t for each of: (a) a positive jump/event and an Exponentially Weighted Moving Average (EWMA) temporal filtering method, (b) a positive jump/event and a neural network (NN) based temporal filtering method, (c) a negative jump/event and an EWMA temporal filtering method; and (d) a negative jump/event and a NN based temporal filtering method;

Figure 7 is a measured signal trace against time illustrating different types of anomaly and drift;

Figure 8 is a flow diagram of a correction determination method according to an embodiment;

Figure 9 is an illustration of an anomaly detection architecture according to an embodiment; and

Figure 10 is a visualization of a continual learning strategy according to an embodiment.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:

- a programmable mirror array. More information on such mirror arrays is given in U. S. Patent Nos. 5,296,891 and 5,523,193, which are incorporated herein by reference.
- a programmable LCD array. An example of such a construction is given in U. S. Patent No. 5,229,872, which is incorporated herein by reference.

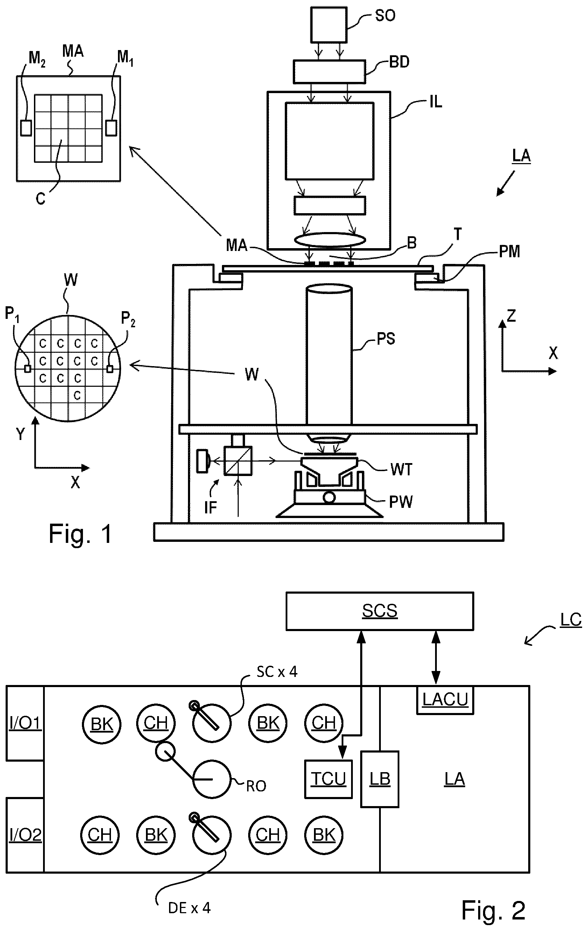

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support structure (e.g., a mask table) MT constructed to support a patterning device (e.g., a mask) MA and connected to a first positioner PM configured to accurately position the patterning device MA in accordance with certain parameters, a substrate table (e.g., a wafer table) WT constructed to hold a substrate (e.g., a resist coated wafer) W and connected to a second positioner PW configured to accurately position the substrate in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illuminator IL receives a radiation beam from a radiation source SO, e.g. via a beam delivery system BD. The illumination system IL may include various types of optical components, such as refractive, reflective, magnetic, electromagnetic, electrostatic, or other types of optical components, or any combination thereof, for directing, shaping, or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system" PS.

The lithographic apparatus may be of a type wherein at least a portion of the substrate may be covered by a liquid having a relatively high refractive index, e.g., water, so as to fill a space between the projection system and the substrate - which is also referred to as immersion lithography. More information on immersion techniques is given in U. S. Patent No. 6,952,253, which is incorporated herein by reference.

The lithographic apparatus LA may also be of a type having two (dual stage) or more substrate tables WT and, for example, two or more support structure MT (not shown). In such "multiple stage" machines the additional tables / structures may be used in parallel, or preparatory steps may be carried out on one or more tables while one or more other tables are being used for exposing the design layout of the patterning device MA onto the substrate W.

In operation, the radiation beam B is incident on the patterning device (e.g., mask MA), which is held on the support structure (e.g., mask table MT), and is patterned by the patterning device MA. Having traversed the mask MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and possibly another position sensor (which is not explicitly depicted in Figure 1) may be used to accurately position the mask MA with respect to the path of the radiation beam B. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks).

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/01, I/02, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

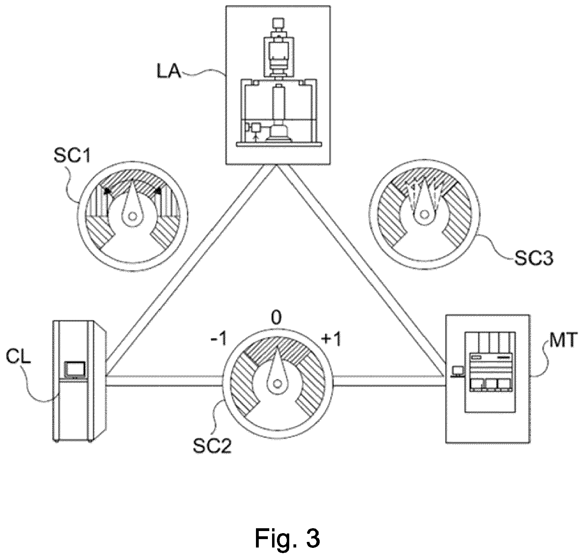

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double white arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT), so as to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

The lithographic apparatus LA is configured to accurately reproduce the pattern onto the substrate. The positions and dimensions of the applied features need to be within certain tolerances. Position errors may occur due to an overlay error (often referred to as "overlay"). The overlay is the error in placing a first feature during a first exposure relative to a second feature during a second exposure. The lithographic apparatus minimizes the overlay errors by aligning each wafer accurately to a reference prior to patterning. This is done by measuring positions of alignment marks on the substrate using an alignment sensor. More information on the alignment procedure can be found in U.S. Patent Application Publication No. US20100214550, which is incorporated herein by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus minimizes these focal positon errors by measuring the substrate surface topography prior to patterning using a level sensor. Substrate height corrections are applied during subsequent patterning to assure correct imaging (focusing) of the patterning device onto the substrate. More information on the level sensor system can be found in U.S. Patent Application Publication No. US20070085991, which is incorporated herein by reference.

Besides the lithographic apparatus LA and the metrology apparatus MT other processing apparatus may be used during IC production as well. An etching station (not shown) processes the substrates after exposure of the pattern into the resist. The etch station transfers the pattern from the resist into one or more layers underlying the resist layer. Typically etching is based on application of a plasma medium. Local etching characteristics may, for example, be controlled using temperature control of the substrate or directing the plasma medium using a voltage controlled ring. More information on etching control can be found in international Patent Application Publication No. WO2011081645 and U.S. Patent Application Publication No. US 20060016561 which are incorporated herein by reference.

During the manufacturing of the ICs, it is of great importance that the process conditions for processing substrates using processing apparatus, such as the lithographic apparatus or etching station, remain stable such that properties of the features remain within certain control limits. Stability of the process is of particular importance for features of the functional parts of the IC, i.e., the product features. To guarantee stable processing, process control capabilities need to be in place. Process control involves monitoring of processing data and implementation of means for process correction, e.g. control the processing apparatus based on characteristics of the processing data. Process control may be based on periodic measurement by the metrology apparatus MT, often referred to as "Advanced Process Control" (further also referenced to as APC). More information on APC can be found in U.S. Patent Application Publication No. US20120008127, which is incorporated herein by reference. A typical APC implementation involves periodic measurements on metrology features on the substrates to monitor and correct drifts associated with one or more processing apparatus. The metrology features reflect the response to process variations of the product features.

In US20120008127, a lithographic apparatus is calibrated by reference to a primary reference substrate. Using an apparatus which need not be the same as the one being calibrated, there is obtained an apparatus-specific fingerprint of the primary reference substrate. Using the same set-up there is then obtained an apparatus-specific fingerprint of a secondary reference substrate. The apparatus-specific fingerprint of the primary reference substrate is subtracted from the apparatus-specific fingerprint of the secondary reference substrate to obtain and store an apparatus-independent fingerprint of the secondary reference substrate. The secondary reference substrate and stored apparatus-independent fingerprint are subsequently used together in place of the primary reference substrate as a reference for the calibration of the lithographic apparatus to be calibrated. Initial set-up for a cluster of lithographic tools can be performed with less use of the costly primary reference substrate, and with less interruption to normal production. The initial set-up can be integrated with on-going monitoring and re-calibration of the apparatuses.

The term fingerprint may refer to a main (systematic) contributor ("latent factor") of a measured signal, and in particular a contributor connected to the performance impact on-wafer or to previous processing steps. Such a fingerprint can refer to substrate (grid) patterns (e.g. from alignment, leveling, overlay, focus, CD), field patterns (e.g., from intrafield alignment, leveling, overlay, focus, CD), substrate zone patterns (e.g., outermost radius of wafer measurements) or even patterns in scanner measurements related to wafer exposure (e.g., heating signature through-lot from reticle alignment measurements, temperature/pressure/servo profiles, etc.). Fingerprints may be comprised within a fingerprint collection, and may be encoded homogenously or heterogeneously therein.

As such, APC identifies correctable variation in a performance parameter such as overlay, and applies one set of corrections to a lot (batch) of wafers. In determining these corrections, corrections from previous lots are taken into account in order to avoid overcorrecting the noise in the measurements. For adequate smoothing of current corrections with previous ones, the history of corrections taken into account may match the context of the current lot. "Context" in this regard encompasses any parameters that identify variants arising within the same overall industrial process. The layer ID, layer type, product ID, product type, reticle ID and so forth are all context parameters that may lead to different fingerprints in the finished performance. In addition to the individual scanners that may be used in a high-volume manufacturing (HVM) facility, the individual tools used for each of the coating, etching, and other steps involved in semiconductor manufacturing can also vary from lot to lot or wafer to wafer. Each of these tools can impose a particular error "fingerprint" on the products. Outside the field of semiconductor manufacturing, similar situations may arise in any industrial process.

To ensure accurate feedback control appropriate to the particular context, different lots (batches) of product units can be treated as separate "threads" in the APC algorithms. Context data can be used to assign each product unit to the correct thread. In the case of a manufacturing plant producing usually high volumes of only a few types of products by the same process steps, the number of different contexts may be relatively small, and the number of product units in each thread will be ample to allow smoothing of noise. All of the lots having a common context can be assigned to their own thread to optimize the feedback correction and the ultimate performance. In case of a foundry producing many different types of product in very small production runs, the context may change more often, and the number of lots having exactly the same context data may be quite small. Using only the context data to assign lots to different APC 'threads' may then result in a large number of threads, with a small number of lots per thread. Complexity of the feedback control increases, and the ability to improve performance for low-volume products is reduced. Combing different lots into the same threads without sufficient regard to their different contexts will cause loss of performance also.

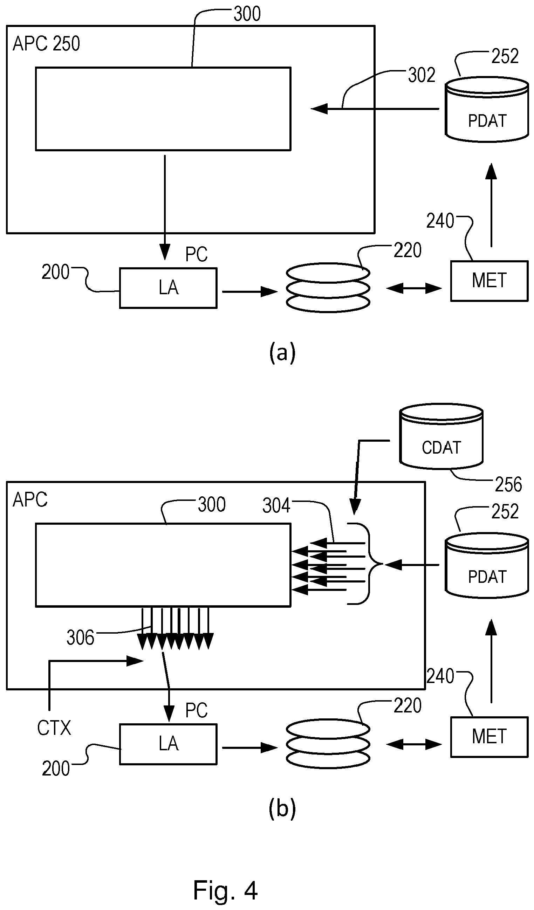

Figure 4 (a) illustrates schematically the operation of one type of control method implemented by APC system 250. Historic performance data PDAT is received from the storage 252, having been obtained by metrology apparatus 240 or other means from wafers 220 that have been processed by lithographic apparatus 200 and associated apparatuses of the lithocell. A feedback controller 300 analyzes the performance parameters represented in the performance data for recent lots, and calculates process corrections PC which are fed to the lithographic apparatus 200. These process corrections are added to the wafer-specific corrections derived from the alignment sensors and other sensors of the lithographic apparatus, to obtain a combined correction for the processing of each new lot.

Figure 4 (b) illustrates schematically the operation of another type of control method implemented by a known APC system 250. As can be seen, the general form of the feedback control method is the same as that shown in Figure 4 (a), but in this example, context data relating to the historic wafers and context data CTX relating to the current wafer is used to provide a more selective use of the performance data PDAT. Specifically, while in the earlier example the performance data for all historic wafers was combined in a single stream 302, and the modified method, context data from storage 256 used to assign the performance data for each historic lot to one of several threads 304. These threads are processed effectively in parallel feedback loops by feedback controller 300, yielding multiple process corrections 306, each based on the historic performance data of wafers in one of the threads 304. Then, when new lots are received for processing, their individual context data CTX can be used to select which of the threads provides the appropriate context data 306 for the current wafer.

There are a number of alternative methods for temporal processing and/or filtering of (feedback) control data (e.g. overlay fingerprints or EPE fingerprints). Such methods include using a low pass temporal filtering method or moving average processing method; e.g., a weighted moving average or Exponentially Weighted Moving Average EWMA. Other methods include a machine learning model such as a Neural Network (NN). For example, an advanced NN filtering method may be trained to learn the appropriate response to temporal behavior based on historic control parameter data and provide a (feedback) correction prediction for the next lot, e.g. in an APC control loop.

A disadvantage of these existing methods is that the temporal processor (e.g., NN or EWMA filter) "learns" based only on the behavior of the control parameters, as can be determined from metrology data of exposed structures. Measured parameter values (e.g., overlay, edge placement error, critical dimension, focus) in the metrology data vary with changes in behavior over time of these control parameters (i.e., a different output is measured for the same control input). Control parameters may be any input parameters of the scanner or other tool used in IC manufacture (e.g., etch chamber, deposition chamber, bonding tool etc.) which control the manufacturing process (e.g., exposure process, etch process, deposition process, bonding process etc.). Therefore, control of the output process, more specifically the formation, configuration and/or positioning of the exposed and/or etched structures, is dependent on these control parameters. As such, it is these control parameters which may be controlled to correct or compensate for any measured error in the metrology data, either in a feedback loop to correct future wafers/lots or as a feedforward correction to correct a present wafer/lot. Note than "learning" in this context includes averaging in a moving average example, as the moving average output effectively "learns" (in a loose sense) to respond to inputted data by averaging the data (its output response changes over time based on the previous few inputs).

The APC control loop described above has a primary task of monitoring drift in metrology data indicative of drift of the control parameter behavior and determining appropriate corrections for the control parameters to address this drift and maintain the measured metrology parameter values within specification (i.e., within a certain acceptable tolerance or "process window") within which the IC device can be expected to function with good probability.

However, not all drift in the metrology data should be corrected for (or followed), only drift in actual parameters of the product features which results from control parameter behavior drift (real drift or systematic change). Other sources of drift in the metrology data may be caused, for example, metrology tool drift, or metrology target imperfections (e.g., fingerprints introduced by overlay target deformation) which are not replicated in the product structure (metrology targets, due to their larger size, can behave differently to product structure when being imaged and/or measured). These drifts are not "real", i.e., they are not actually indicative of drift in the exposure (or other processing) process affecting the product structure quality. A metrology tool which has drifted and measures less accurately resulting in out-of-spec metrology parameter values does not mean, of course, that the product on wafer is out of spec; therefore this metrology tool drift should be ignored by the APC loop. Also, alignment mark deformation may induce a drift which can be captured by the APC loop, which should not be followed.

As well as (e.g., relatively steady) drifts, the metrology data may indicate a "jump" or "step" in the process, e.g., a sudden, relatively large change in the measured parameter values indicative of a more sudden change in control behavior. As with drift, such jumps may be indicative of something that should be followed and corrected for (a systematic anomaly or disturbing event), or alternatively something that should be ignored (e.g., a non-systematic/transient anomaly or disturbing event). A specific example of an anomaly being indicative of something that should be followed is when a calibration state of the scanner is changed. This may, for example, manifest as a jump in magnification. This change in state should be incorporated in an updated feedback control, because the change is permanent. By contrast, a scanner lens may be subject to a lens "hiccup" or transient lens anomaly which may also manifest itself as a jump in magnification. However, such a lens hiccup is a one-time deviation and should not be followed by the feedback control as it will not be present in the next lot.

The APC controller has no way of knowing which drifts and/or jumps should be acted upon and which should be ignored based on the metrology data alone, as these different types of drifts and jumps are indistinguishable within the metrology data; i.e., a lens hiccup and a calibration state jump will look the same in the metrology data. More specifically, a neural network used as a temporal filter can be trained to learn how to respond to certain trends or events (e.g., drifts and/or jumps). However, without any knowledge of the underlying reasons for these effects, a neural network based control system cannot be sure to respond appropriately (e.g., follow, ignore or partially follow/partially ignore (e.g., according to an appropriate non-binary weighting).

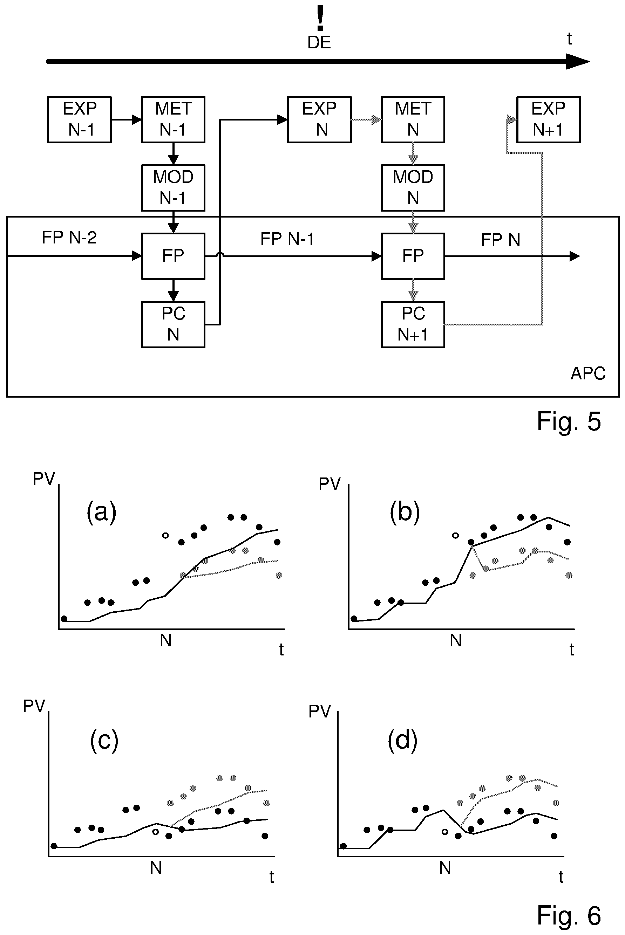

Figure 5 is a flow diagram of (e.g., part of) an IC manufacture process, relating to exposure, metrology and APC control of the process for a number of wafer lots. The example is abbreviated and may include etch steps, deposition steps, wafer bonding steps etc. depending on the specific process. Time t is shown as traveling left to right. An exposure of lot N-1 EXP N-1 is performed and then measured MET N-1. A modeling step MOD N-1 is performed to fit a model to the metrology data, e.g., such that the metrology data can be described more efficiently. Within the APC controller, a filtered fingerprint FP is determined (i.e., based on the modeled metrology data and the fingerprint from at least the previous lot FP N-2, and possibly additional data (e.g., from other lots) if a NN is used as the temporal filter). Based on this fingerprint, a process correction PC N for the next lot (lot N) is determined). While the metrology, modeling, fingerprint and correction determination steps are shown as occurring simultaneously, they of course cannot literally do so, only effectively within the context of the flow shown. Following this, exposure of lot N EXP N is performed using the determined corrections PC N. However, at the time of this exposure, a disturbing event DE occurs, e.g., which may manifest as a jump in the metrology data MET N. The remainder of the flow is the same as for lot N-1, but the gray arrows indicate that this flow and the modeled data MOD N, fingerprints and corrections for the next lot PC N+1 will be impacted by the disturbing event DE.

Figure 6 illustrates how a control parameter might follow the data according to a control strategy, depending on whether a jump or disturbing event is real (systematic) or false/a one-time event (non-systematic). Each plot is a plot of a control parameter value PV or a metrology parameter value (e.g., overlay) dependent on the control parameter against time (or lot). In each plot, each point up to lot N represents a value for that lot. The point for lot N (represented as a white circle) is indicative of a jump (positive jump in Figures 6(a) and 6(b) and a negative jump in Figures 6(c) and 6(d). Beyond that, each lot is represented by two points: a first point (black) representing what would be expected to be seen if the jump was real, and a second point (gray) representing what would be expected to be seen if the jump was false/one-time event. The line represents a control signal correction as might be determined by the APC loop based on the metrology points. Again, after lot N, there are two lines, a black line following the black points and a gray line following the gray points. The distance between the control signal correction (line) and the corresponding control parameter point is indicative of the control performance; the closer the line is to a corresponding point, the better the correction and control performance.

Figure 6(a) shows a positive jump and an EWMA based control. The EWMA is slow in following a real jump. A hiccup (in this one example) actually helps the control, as it reduces the control lag (the gray line for lot N+1 is much closer to the parameter value than it would be if no jump occurred). Figure 6(b) shows a positive jump and a NN based control. The NN is better at following the corrections, and follows the real jump well, assuming it has been trained to do so. It also mistakes the hiccup for a real jump, which means that, in the hiccup case, lot N+1 could well be exposed out-of-spec. This could also be the other way around depending on how the NN is trained; i.e., if it were trained to ignore a jump and assume it a hiccup, or somewhere in between (e.g., when it has been trained about both and may respond with an intermediate correction). Figures 6(c) and 6(d) show equivalent plots to Figures 6(a) and 6(b) respectively, with a negative jump. Comparing Figure 6(c) to Figure 6(a), it is now apparent that a negative hiccup (false jump) in this example harms the control significantly for a number of future lots.

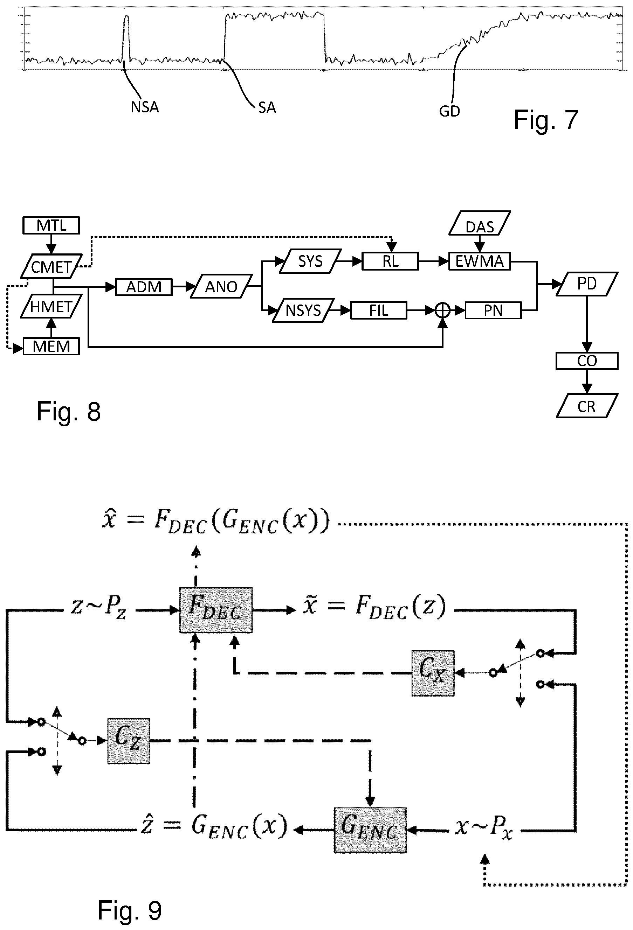

During a lithography cycle, a parameter of interest (e.g., overlay although it could be another parameter indicative of imaging performance) of each exposed lot is measured using a metrology tool, generating substantial amounts of streaming multivariate time series data (i.e., the metrology data described in the Figure 5 above and Figure 8 below may comprise such multivariate time series data). This allows for a feedback loop to be incorporated into the control strategy, where the temporal relationship within the measurements of previously exposed lots can be analyzed by the controller to predict a parameter of interest (e.g., overlay) of future lots. Based on this, a correction optimization for one or more control parameters of a manufacturing tool used in the integrated circuit (IC) manufacturing process may be performed to yield a correction. The correction may be for a scanner parameter (i.e., a control parameter of the lithographic exposure tool), although it may be for other tools such as an etcher. The correction optimization may even comprise a co-optimization for two or more of such tools. The correction optimization aims to determine a correction which improves the parameter of interest performance with respect to that predicted (e.g., minimizes overlay compared to the predicted overlay).

In an overlay context, lots are typically exposed sequentially, and overlay parameters continually estimated, generating substantial amounts of multivariate time series data. To minimize overlay during a lithography cycle, a feedback loop may be incorporated into the control strategy, such as the aforementioned APC control loop. As part of the feedback control, a mathematical relationship within the estimated overlay parameters of previously exposed lots can be analyzed to predict the parameters of future lots. Semiconductor processes are highly dynamic and non-stationary, which can cause the overlay to follow complex spatio-temporal patterns. The controller aims to compensate for this through modification of the recipe. Specifically, before exposure of the next lot, the scanners' settings can be adjusted to anticipate the overlay using a correction optimization which is based on a set of predicted overlay parameters, as predicted by the controller. In general, this can be done by calculating a fingerprint for correcting the overlay of the next lot, or, if it can be determined that the predictions can be related to a certain operating condition within scanner, e.g., such as heating, the information can directly be fed back to the scanner to adjust these operating conditions within the scanner.

Hence, an objective of the controller may be to predict a set of overlay parameters for all future wafers before exposure based on the available history at that point in time. This may comprises a multivariate time series forecasting task, where the goal is to prevent future errors by predicting the behavior of the machine.

Additional restrictions may be imposed by practical applications; for example the algorithm should consider the current and previous states to predict the overlay parameters before exposure of the corresponding lot in order to make timely adjustments to the machine settings, limiting the allowed computational time (e.g., imposing a time constraint on performing such predictions based on machine settings). The system observes each data record sequentially as they arrive and any processing or learning may be automated without manual intervention or parameter tweaking.

In real-world time series data from complex mechanical devices, there are scenarios when the behavior of the machine changes unexpectedly based on usage or external factors. Abrupt changes in overlay parameters may be caused by systematic sources of variation that often lead to the system's new definition of "normal", which can be compensated by appropriate control adjustments. Causes include multiple manual regime or control setting changes, external phenomena (e.g. environmental conditions), automatic calibrations, auxiliary information (e.g. test run) or any additional factors that the controller does not take into account. Apart from the mechanics of the exposure system, other non-systematic sources may vary significantly enough to induce random high frequency fluctuations that reduces overlay accuracy. These scenarios can occur at any time during the process leading to periods in the streaming data that are inherently unpredictable, thus rendering ineffective forecasting methods, even for the very near future. A controller that is unable to adapt to the unpredictable behavior can have severe consequences for the predictions of the overlay parameters causing the feedback loop to make incorrect adjustments, which may ultimately lead to an increase in overlay and malfunction in the final device

To predict overlay parameters for overlay control (e.g., APC), it is known to use an Exponentially Weighted Moving Average (EWMA) based controller. EWMA requires very little computational effort and storage of metrology data. This low-pass filter has proven to smooth out minor variations of the data streams. However, EWMA by definition is a reactive control scheme that lags in time making it unable to keep up with the abrupt yet permanent systematic changes in the time series. In addition, EWMA responds to non-systematic high frequencies, which can have severe consequences for predictions of overlay parameters of subsequent lots. EWMA can be designed to react quickly to these fast changes, but as a result will be very volatile and lose accuracy elsewhere. Furthermore, EWMA does not exploit the spatio-temporal correlation structure and other dependencies amongst the multiple overlay parameter time series by handling the forecasting problem in a multivariate setting.

An objective of concepts disclosed herein is to develop a predictive controller that improves the prediction accuracy on which the control adjustments are based and thereby decreases parameter of interest errors, e.g., to reduce overlay. However, as has been described, there are scenarios when the behavior of the lithography machine changes unexpectedly based on usage or external factors. Such scenarios may cause short or long lived abrupt changes in the streaming data that are inherently unpredictable. Unpredictable behavior can have severe consequences for the controller's predictions of future lots causing the feedback loop to make incorrect control adjustments, which may ultimately lead to an increase in overlay or even malfunction in the final device. Given the unpredictable behavior of the lithography machine, it is proposed to enable the controller to adapt automatically to systematic long lived changes while preventing response to nonsystematic transient changes that do not carry any useful information.

An adaptive controller is proposed which comprises of two main modules: a prediction module and an anomaly detection module. The prediction module predicts a future set (e.g., the next set) of one or more parameters of interest (e.g., one or more overlay parameters) at each step of a lithography cycle. The anomaly detection module may be configured to detect anomalies or disturbing events in the streaming data. An automated system may be provided which combines the two networks by distinguishing between at least two types of anomalies identified by the anomaly detection module and alters the prediction strategy depending on the specific type.

As such, a method for predicting a parameter of interest of a manufacturing process for manufacturing integrated circuits, the method comprising: obtaining metrology data relating to the parameter of interest; applying a first prediction sub-module to said metrology data to obtain non-anomalous prediction data; detecting anomalies in said metrology data (e.g., using an anomaly detection module); dividing said anomalies into systematic anomalies and non-systematic anomalies; using a first prediction strategy on said non-systematic anomalies to obtain first anomaly prediction data; using a second prediction strategy on said systematic anomalies to obtain second anomaly prediction data; wherein said first prediction strategy is different to said second prediction strategy; and combining said first anomaly prediction data and/or second anomaly prediction data with said non-anomalous prediction data to obtain a prediction of the parameter of interest.

The metrology data may comprise at least current metrology data (e.g., from a currently processed lot) and historic metrology data (e.g., from previously processed lots and/or as simulated). For example, the metrology data may comprise current measured values of said parameter of interest and historic measured values of said parameter of interest. The metrology data may comprise simulated or artificial data and/or real (i.e., actually measured) metrology data. Where artificial data is used, there will be a dependence on actual occurrence before training. Reference can be made, for example, to US 20210405544 A1 which is incorporated herein by reference. The metrology data may comprise pre-exposure metrology data (e.g., leveling data, heating data, alignment data) and/or post-exposure metrology data (e.g., overlay, CD, focus or another measured parameter of interest). The metrology data may comprise context data (such as exposure time, changes in device design, production gap data, change of status in non-scanner tools, e.g., etcher/etch chamber). Any of these metrology data types may be comprised within the metrology data.

The steps of detecting anomalies in said metrology data and dividing said anomalies may comprise detecting and dividing said anomalies in at least said current metrology data.

The prediction may be used to determine a correction, e.g., for the lithographic system or other tool in an IC manufacturing system (e.g., scanner, etcher or other tool used in IC manufacture), e.g., using a correction module (e.g., to determine a correction fingerprint) or for use directly by the scanner or other manufacturing device to modify an operating condition of the scanner/ other manufacturing device.

The anomaly detection module may be configured to trigger an alarm on detection of anomalous or unpredictable behaviour in the (streamed) metrology data. An automated system based on detection of anomalies and identification of such anomalies as being either systematic or non-systematic enables the prediction module to automatically adapt to abrupt permanent changes and avoid responding to abrupt transients changes which do not carry any useful information.

The modules may be trained and optimized while the lithography cycle is running using a continual learning strategy which updates the controller system incrementally to account for any gradual changes in the streaming data distribution. For example, at each iteration, the anomaly detection module receives a new observation from the metrology tool and appends it to the previous observations it has received. Based on the entire (currently available) multivariate time series, the anomaly detection module employs a reconstruction-based unsupervised anomaly detection method to detect unpredictable behaviour in the streaming data. The output of the anomaly detection module may be a set of subsequences identified as irregular or anomalous. Next, the anomaly detection module may distinguish the nature of each anomalous subsequence and categorize it as either systematic or non-systematic.

All sub-sequences that are classified as a non-systematic may have a first prediction strategy applied (e.g., using a first prediction sub-module). The first prediction strategy may initially comprise a processing of the metrology data corresponding to the non-systematic anomaly; e.g. to smooth the metrology data sub-sequences, e.g., by application of a filter (e.g., a smoothing filter). The first prediction sub-module may comprise a prediction model or prediction network to determine a prediction based on this smoothed metrology data at the next training step. In this way, the prediction module is prevented from responding to abrupt transient changes.

For systematic anomalies (e.g., long lived changes detected in real time), the first prediction strategy may be automatically replaced by a second prediction strategy (e.g., using a second prediction sub-module). The second prediction strategy may comprise applying a low pass temporal filtering or moving average processing method; e.g., a weighted moving average or Exponentially Weighted Moving Average EWMA. This algorithm may exclusively utilize the data which arrives after the anomaly occurred, which allows the controller to adjust instantaneously to the system's new definition of normal. While employing the newly initialized EWMA, the first prediction sub-module (prediction network) may be fine-tuned automatically using incoming data and may replace the EWMA after data from a set number of new lots have been received.

In an embodiment, the EWMA may comprise a short-series EWMA (ssEWMA). Such a ssEWMA is described in R.Good & K Chamness: "Small-Sample Controller State Estimation: Initializing the EWMA Filter", AEC/APC Europe April 20, 2007, which is incorporated herein by reference.

It should be appreciated that application of a low pass temporal filtering or moving average processing method such as an EWMA is only an example of a second prediction strategy. The second prediction strategy may comprise applying any suitable predictor network, e.g., a neural network or Bayesian predictor. In an embodiment, a machine learning model or neural network may be trained to select an appropriate second prediction strategy based on the detected systematic anomaly.

More specifically, if the current observation is identified as a systematic anomaly, the predictions of the prediction network are not passed on to the correction module for the corresponding time series. Instead, a new EWMA algorithm may be initialized to predict a (e.g., predefined) number ($t_{EWMA}$) of time points of the time series which comprise the anomaly, these $t_{EWMA}$ time periods being the $t_{EWMA}$ immediately after the anomaly. The reason for this is that the first few predictions produced by the prediction network after the systematic anomaly might be unstable for the time series that the anomaly occurred in, given the drastic shift in the input data. This phenomenon is known as catastrophic forgetting; the network tends to completely and abruptly forget previously learned information upon learning new information.

The newly initialized EWMA only uses data that arrives after the systematic anomaly. Therefore, the controller does not need time to adjust. To clarify, if the first input to the new EWMA is the first observation after the abrupt change, its prediction for the next observation is exactly equal to that input. The number $t_{EWMA}$ of time periods predicted using the EMWA may be determined empirically (e.g., it may be between 10 and 1000, between 10 and 500, between 10 and 400, between 10 and 300, between 20 and 300 or between 30 and 300).

In an embodiment $t_{EWMA}$ may be set by the user to a preferred value or the user can use recommended settings based on observations. Moreover, the transition from EWMA to predictor can be gradual, using relative weights which increases the impact of prediction based parameters and decreases the impact of EWMA based parameters over a period of time.

The prediction network prior to the anomaly may be fine-tuned using the newly arriving data by retraining it (e.g., multiple times) after detecting the systematic anomaly such that the predictions have time to stabilize using a continual learning strategy.

All non-anomalous subsequences are simply passed on to the prediction model/prediction network to determine non-anomalous prediction data relating to non-anomalous metrology data.

Figure 7 illustrates three different types of irregularities which may be defined: an abrupt transient change (non-systematic anomaly) NSA, an abrupt shift which is long lived (systematic anomaly) SA, and a gradual drift GD in the streaming data distribution. The objective of the anomaly detection module is to alert on the two abrupt changes NSA, SA. A continual learning strategy may be employed such that the prediction network is able to adapt to gradual changes GD; therefore it is proposed that the anomaly detection module does not raise an alarm for gradual shifts in the distribution. While these categories do not include all abnormal behaviour, these abrupt anomaly types often occur in overlay control and cause the largest decrease in performance for the current EWMA-controller based methods. However, the types of anomalies may be varied to serve different tasks in predictive maintenance.

A non-systematic anomaly may comprise a (problematic) random high frequency that the prediction network should ignore. A non-systematic anomaly may be defined as an abrupt transient change. These types have no systematic cause and are assumed to occur in the parameter time series separately. Non-systematic anomalies do not include periodic shifts. The lots corresponding to the non-systematic anomaly may cause malfunction in the final device and need to be reworked. These anomalies cannot be anticipated and the objective is not to predict them as this is impossible by definition. Because EWMA control schemes are reactive, they lag behind in time and predictions subsequent to a non-systematic anomaly will be affected. This discrepancy may lead to wrong corrections and ultimately to increased overlay.

A systematic anomaly may be defined as an abrupt shift of the signal mean which is long lived. Often, the systematic anomaly is extremely long lived or does not return to its previous state at all. This kind of anomaly does not necessarily indicate machine issues and has a relevant cause that the controller should adapt to. Causes may include external phenomena (e.g. environmental conditions), auxiliary information (e.g. test run), or any additional factors that the controller does not take into account, including regime or control setting changes. The systematic anomalies only occur occasionally and have a high probability of occurring in multiple parameter time series simultaneously. For example, calibration often causes an unpredictable shift in multiple overlay model parameters simultaneously. For example, a lot of calibrations will actually cause a predictable shift, which can be coupled to a neural network for control.

An anomaly is often caused by an unknown effect, indicating that the anomaly network may not have all the information it should. As an example, a long gap in lot production will often cause an anomaly if exposure time is not taken as an input to the anomaly detector. Thus, significant anomalies may the trigger anomaly detection module to require or request more information from the user.

At each iteration of the lithography cycle, the anomaly detection module receives a vector-valued observation (e.g., a new element for each parameter of interest time series in a collection of time series). The output of the anomaly detection module is a set of anomalous sub-sequences for every time series in the collection. Given the rarity of systematic anomalies and that they occur in multiple time series simultaneously by definition, the type of anomaly may be distinguished based on the following domain rule: if multiple elements of a single observation at a specific time point are identified as anomalous, those elements are identified as systematic anomalies; otherwise they are identified as non-systematic anomalies. This is one method for distinguishing anomalies, other methods for distinguishing anomalies are possible, including those which identify addition anomaly types.

Figure 8 is a flow diagram describing such an arrangement. From memory MEM, previous or historic metrology data HMET from historical lots/wafers is available. Current metrology data CMET may be obtained from a metrology tool MTL measuring the present lot/wafers. This information is fed to an anomaly detection module ADM, which may comprise a machine learning model or neural network, to identify anomalies that can create issues with predictor. The output from the anomaly detection module ADM is a sequence of anomalies ANO which are divided into systematic anomalies SYS and non-systematic anomalies NSYS.

The systematic anomalies SYS may have one or more pre-established rules RL applied. The rules may optionally be updated with information from the current metrology data as it arrives. The pre-established rules RL may be set based on known domain knowledge. Once the network has sufficient data, it can determine its own rules and optimize performance further. By way of specific example, these rules RL may comprise a short computation to determine if the newest observation is comprised in the systematic anomalous sub-sequences. If so, the indices of the sub-sequences that the newest observation occurs in may be saved and EWMA employed to the time series corresponding to these indices. Data after Sys DAS comprises the data of the periods after the last systematic anomaly occurred with a maximum number of time instances $t_{EWMA}$. If EWMA is being used, it may output a univariate one-step ahead prediction for each time series that the anomaly occurred in. These values replace their corresponding values in the multivariate one-step ahead prediction produced by the prediction network PN.

The systematic anomalies are used in a predictor which is more robust (compared to prediction network PN) in handling such anomalies. As already described, a simple low cost implementation may comprise an EWMA triggered by the anomaly detection module ADM. Alternatively, this first prediction sub-module can also comprise any network or model, including another machine learning model or neural network, that is designed to handle systematic anomalies.

The non-systematic anomalies NSYS may be smoothed with a low pass filter FIL, combined with the continuous data flow (e.g., the smoothed data may replace this flow for time periods comprising the non-systematic anomalies) and fed to a prediction module or prediction network PN. This prediction network may comprise a machine learning model or neural network.

The outputs from EWMA and prediction network PN may be combined to produce a prediction PD for overlay control of the next lot. Depending on the situation, the output can be entirely from EWMA, entirely from the prediction network PN or can be a combination of both, e.g. a weighted combination with the weights automatically determined or selected by user. For example, the weighting may be varied over time to effect a gradual transition from one strategy to the other (e.g., from EWMA to prediction network). A correction optimization CO step may use the prediction to determine a correction CR .

It can be appreciated that the anomaly detection module ADM may receive all available history and re-classify all available data points as anomalous or non-anomalous (before distinguishing the type of anomaly) at every point in time. The anomaly detection module ADM always receives true values and not smoothed out versions. Therefore, the anomaly detection module ADM might be able to identify a sub-sequence of a time series as anomalous at a certain point in time and re-classify it as non-anomalous at another point in time or *vice versa.* To clarify, the disclosed arrangement can automatically adapt if at a later stage during the cycle, the observation, which was previously identified as anomalous, turns out to be part of a temporal pattern.

In an embodiment, the anomaly detection module ADM may comprise a reconstruction based method such as implemented by an adversarial machine learning model; e.g., a generative adversarial network (GAN) based network. In particular, the anomaly detection module ADM may comprises a cycle generative adversarial network or CycleGAN based network, which works as a reconstruction based method for anomaly detection. A specific implementation may comprise a Cycle-consistent Wasserstein GAN with Gradient Penalty (CycleGAN-WP), such as described in Alexander Geiger et al. "TadGAN: Time series anomaly detection using generative adversarial networks" 2020 IEEE International Conference on Big Data (Big Data). IEEE. 2020, pp. 33-43, which is incorporated herein by reference.

Such reconstruction based networks have advantages over traditional fixed outlier based methods, e.g., n-sigma filter, which are based on the prediction that a certain signal is anomalous if it exceeds a pre-defined threshold. A main issue with such outlier based approaches is that they may lose accuracy when the data is dynamic. A reconstruction based method has the advantage of mapping observations to a lower dimensional space and then decoding the encoded point, assuming that anomalous observations cannot be reconstructed as well as regular samples since information is lost during encoding.

Figure 9 shows an exemplary anomaly detection module ADM architecture based on CycleGAN-WP. The path of reconstruction is depicted by the dash-dotted line. The dashed lines represent the adversarial Wasserstein losses and the dotted line represents the forward cycle-consistency loss.

Formally, given the multivariate time series $X = [x^{<l>}, ..., x^{<T>}]$, the aim of unsupervised reconstruction-based time series anomaly detection is to identify a collection of anomalous sub-sequences $A_{i,seq} = \{a_{i,seq}^1 ... a_{i,seq}^K\}$ for each time series $i$, where $a_{i,seq}^k$ is a continuous time sequence which appears to deviate from expected behavior and i is the index of the parameter of interest time series. The data which anomaly detection module ADM receives from the metrology tool may be divided into sub-sequences $X = \{x_t\}_{t=1}^N$ (training samples), e.g., using a sliding window with a pre-fixed window size and step size (e.g., a step size of one). Here, $x_t \in \mathbb{X}$ denotes a time sequence window of length $m_T$ ending at time step $t$ and $N = T_X - m_T$ is the total number of sub-sequences. The model learns two mapping functions $G_{ENC} : X \to Z$ and $F_{DEC} : Z \to X$ through leveraging adversarial learning techniques. The two mapping functions can be viewed as generators. Here, X represents the domain of the input data and Z represents the latent domain, where random vectors z may be sampled from a standard multivariate normal distribution to represent white noise, e.g., $z \sim \mathbb{P}_Z = MVN(0,1)$.

With the two generators, the input time series can be reconstructed as follows: $x_t \to G_{ENC}(x_t) \to F_{DEC}(G_{ENC}(x_t)) = \hat{x}_t$, where $\hat{x}_t$ denotes the reconstructed time series window. In such an exemplary arrangement, the two generators are not two separate encoder-decoder networks such as in a standard CycleGAN. Instead, the generators combined form one encoder-decoder architecture. In other words, the encoder and decoder are both treated as separate generators. Generator $G_{ENC}$ serves as a single encoder mapping the input time series into the latent space and generator $F_{DEC}$ is a single decoder transforming the latent vector into the time series reconstruction. Bidirectional Long short-term memory networks (LSTMs) may be used as the base models for the generators to capture the temporal correlations of the time series distributions.

A full high-level objective differs from the full objective of the CycleGAN in two ways:

- (1) CycleGAN applies the adversarial loss from the original GAN to both generators and their associated discriminators. Instead, the network described here employs two adversarial WGAN critics Cx and Cz with Wasserstein losses as the adversarial loss. Critic Cx encourages generator $F_{DEC}$ to translate z into outputs indistinguishable from the real time series sequences from domain X, while Critic Cz evaluates the performance of the mapping into the latent space. Similarly to the generators, bidirectional LSTMs may be used for both critics. Wasserstein loss suffers less from vanishing gradients and mode collapse. In addition, the critic networks return scores of how real or fake the input sequence is. Therefore, the trained Critic Cx can directly serve as an anomaly measure.

- (2) The network only employs forward consistency loss: for the original input time series from domain X, the reconstruction cycle must be capable of bringing $x_t$ back to the original time series, i.e. $x_t \to G_{ENC}(x_t) \to F_{DEC}(G_{ENC}(x_t)) \approx x_t$. With adversarial losses without forward cycle-consistency, there is no certainty that the learnt function can transform each particular input to the intended output. Adding forward cycle-consistency loss prevents contradiction between $G_{ENC}$ and $F_{DEC}$. However, the generators do not have to satisfy backward consistency loss, i.e. $z \to F_{DEC}(z) \to G_{ENC}(F_{DEC}(z)) \approx z$, as there is no interest in reconstructing the exact latent vector. Furthermore, considering the target is anomaly detection, the L2-norm (Euclidean norm) may be used instead of the L1-norm used in CycleGAN, since it imposes a greater penalty when observations are further away, emphasizing the impact of anomalous values. The generators may be trained using the adapted cycle-consistency loss between the original and the reconstructed samples.

Assuming a sliding window approach with a step size of one, each time point in a time series belongs to multiple input time windows. Evidently, each element of a time series has multiple reconstructed values. To calculate a single reconstruction value for every element, the median over the multiple reconstructed values may be taken, corresponding to one specific time point in a time series. The result is a reconstructed time series $\left[\hat{x}_i^{\langle 1\rangle}, \ldots, \hat{x}_i^{\langle T\rangle}\right]$ for each time series in the collection. To calculate the discrepancy between the real univariate time series $x_i = \left[x_i^{\langle 1\rangle}, \ldots, x_i^{\langle T\rangle}\right]$ and its reconstruction $\hat{x}_i = \left[\hat{x}_i^{\langle 1\rangle}, \ldots, \hat{x}_i^{\langle T\rangle}\right]$, termed the reconstruction error $r(x_i)$, dynamic time warping (DTW) may be applied since it is robust to time shifts by allowing for warping of the time axis. After training the network with cycle-consistency loss, the critic network Cx may be optimized to differ whether a given sample comes from the training data or the generative model $F_{DEC}$ with high sensitivity. Thus critic Cx may be seen as a network that captures the distribution of the input data. The score the critic Cx outputs is analogous to the confidence level of how sure the model is that the signal given is real. Therefore, the resulting score is of relevance for distinguishing anomalous sequences from normal ones, since anomalies do not follow the expected temporal pattern by definition. Informally, if the critic returns a low score (fake) given a real training sample input, the training sample does not follow the expected behavior and can be assumed therefore to be anomalous.

The critic score may be computed for every univariate training sample, e.g., $\left\{x_{i,t}\right\}_{t=1}^{N} \forall i$. Critic $C_X$ returns a critic score for every sub-sequence, resulting in multiple critic scores for each time point per time series, similar to the reconstruction error. A Kernel Density Estimation (KDE) with a Gaussian kernel may be applied on every collection of critic scores corresponding to a specific time point and the smoothed value set equal to the maximum value. The result may be a smoothed critic score for each time point for every time series $C_x(x_i) = \left[c_i^{\langle 1\rangle}, \ldots, c_i^{\langle T\rangle}\right]$.

Both scores can be merged to obtain a final anomaly score for every time step. However, the critic scores and reconstruction errors cannot directly be combined to obtain an anomaly score. All non-anomalous values will have a similar high critic scores and low reconstruction errors, while an anomalous value will result in an unusually low critic score and high reconstruction error. Therefore, the reconstruction errors r(x) and critic scores $C_x(x)$ may be normalized by calculating their respective absolute z-scores ($Z_r$ and $Z_c$). Given that an extremely normal value with an extremely high critic score and extremely low reconstruction error does not exist per definition, a large z-score indicates a high anomaly score. The scores may be merged into a single value $a(x)$ (anomaly score) for each time point by taking the point-wise product between the two vectors $a(x) = Z_r(x) \odot Z_c(x)$.

To determine whether computed anomaly scores constitute anomalies, a locally adaptive thresholding technique may be applied to classify each point as anomalous or normal. First, the anomaly scores may be passed through a smoothing moving average algorithm to obtain the smoothed anomaly scores. Then, a sliding window approach may be applied over the sequence of smoothed errors, where for each window the current static threshold is set to a number of (e.g., 4) standard deviations from the window mean. Intuitively, computing the threshold over a time window instead of the whole sequence helps to identify anomalies which are normal respect to the entire data stream, but anomalous only in the context of the data around it. Finally, the points with a smoothed anomaly score higher than the local threshold may be classified as anomalous, resulting in a set of anomalous sub-sequences for each time series: $A_{i,seq} = \left\{a_{i,seq}^1 \ldots a_{i,seq}^K\right\}$ with $a_{i,seq} = [a_{start(k)}, \ldots, a_{end(k)}]$.

A smart continuous learner (CL) may be employed in the concepts disclosed herein, with an aim that the hyper parameter optimization required for the prediction network does not slow down the overlay control. Both hyper-parameter optimization and training a model given a set of hyper-parameters may take more than an allowed computational time e.g., as defined by the interval between exposure of two consecutive lots. Hence, the continual learning strategy may be used to obtain the optimal model while the lithography cycle is operating and update the model automatically to gradual changes.

CL may employ a Bayesian optimization and a 'gap and stride' strategy to continuously learn while the predictor network is working. The Bayesian optimization may be used to create a surrogate model so that the predictor model is not rebuilt every time from scratch. The stride determines the number of time points between two consecutive training steps. The gap determines the number of time points between the start and end of the hyper-parameter optimization.

The learning tasks comprise streaming data which arrives in a sequential mode, and the underlying data distribution keeps changing due to the non-stationary nature of the real-world lithography environment. Both the anomaly detection module network and prediction network should be trained while the lithography cycle is running. For automatic hyper-parameter optimization of the prediction network, it is proposed to employ Bayesian Optimization (BO), which enables application of incremental model learning, where the model is not rebuilt from scratch each time but is updated automatically using the new information received. As a result, the network is able to reduce the cost associated with training the models and allows for a more gradual adaptation to data changes, which is particularly useful in streaming settings. By selecting the next input values based on those that have performed well in the past, BO limits the cost of evaluating the objective function. Briefly, Bayesian optimization finds the value that minimizes an objective function by building a probability model (surrogate function) on past evaluation results of the objective. The surrogate, that maps input values to a probability of a loss, is cheaper to optimize than the objective. By applying a criterion (e.g. Expected Improvement) on the surrogate, the next input values to assess are chosen. After sufficient evaluation, the surrogate function will resemble the objective function. In the present case, the objective function may be the validation error of the prediction network given a set of hyper-parameters.

Consider a new hyper-parameter optimization is started using the current available history. The model that existed prior to the start of the optimization continues to make predictions while the optimization is running. The current optimization cannot take into account the new true observations that are arriving while it is running. Once the optimization is terminated by the time limit, the model is retrained on the current history (both training set and validation set) using the best resulting hyper-parameter combination and the updated model takes over until the next retraining step. Immediately after the optimization is finished, a new optimization continues including the data that arrived during previous optimization. This allows the optimization to run for longer and consider more hyper-parameter combinations.

The anomaly detection module may have a pre-fixed hyper-parameter set (e.g., based on expert knowledge and/or training on artificial data) and may be retrained after a set number of new observations have arrived to effectively update the model with new information. The different possible strategies may be defined by introducing two parameters: stride and gap. The stride determines the number of time points between two consecutive training steps. The gap determines the number of time points between the start and end of the hyper-parameter optimization. Put differently, the gap determines the allowed computational time of each hyper-parameter optimization defined as a number of time points. Both variables are expected to have a different effect on the model performance. There exists a trade-off: if the gap is chosen to be large, the hyper-parameter optimization is able to evaluate more combinations and will, in theory, result in a lower validation error, but the history used for the hyper-parameter optimization is far away from the prediction range of the model based on the resulting hyper-parameter set. For a fixed hyper-parameter set, retraining after a number of new observations have come in, essentially updates the model with new information. Intuitively, a smaller stride would result in better predictions, since the model is more up to date. The optimal values for the stride and gap may be determined empirically.

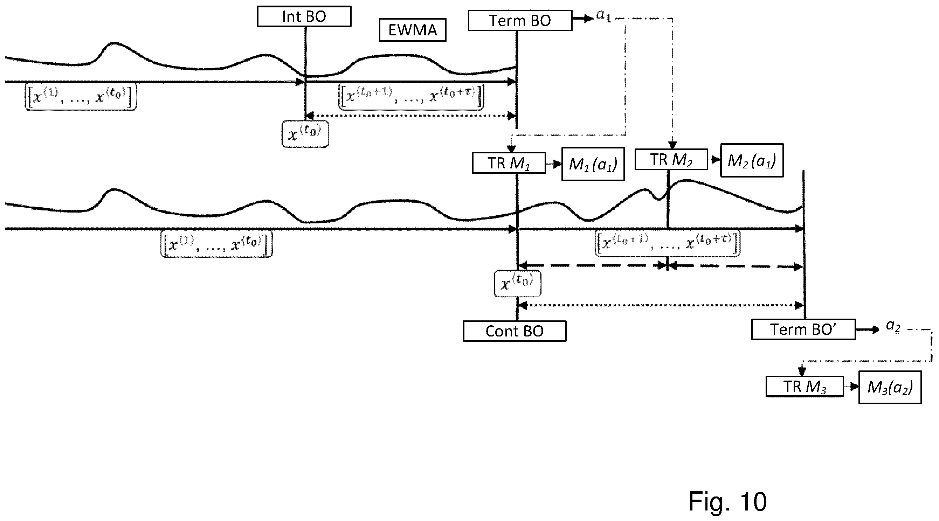

Figure 10 is a visualization of a continual learning strategy according to an embodiment. A step of initializing Bayesian optimization Int BO may be performed while EWMA is predicting. This Bayesian optimization may be terminated Term BO after a period (dotted line) to obtain a first hyper-parameter set $a_1$. A first model may be trained TR $M_1$ using first hyper-parameter set $a_1$ and the next stride time steps predicted. Simultaneously, Bayesian optimization may be continued Cont BO where the previous optimization ended, including the time points which arrived during the previous optimization. Model $M_1$ may be retrained TR $M_2$ using same hyper-parameter set $a_i$.to obtain second model $M_2$ after stride (dashed line) number of observations have been received. This Bayesian optimization may be terminated Term BO' after a second gap to obtain second hyper-parameter set $a_2$. The model $M_2$ may be retrained TR $M_3$ using new hyper-parameters $a_2$ to obtain model $M_3$. These steps may be repeated as required. Note that the stride here is set to be half the size of the gap.

The outputs from methods disclosed herein can be used in traditional APC control (such as creating a new fingerprint (spatial distribution) for next lot) but also can be fed back directly to the scanner as a method to improve the scanner settings (scanner based feedback controls) . For example, if certain parameters have a direct correlation with a scanner setting, then predictions of these parameters can be used to directly alter that scanner setting, instead of correcting it though an APC loop.

It should be appreciated that the metrology data used in the methods described herein may comprise synthetic metrology data (alternatively or in combination with non-synthetic metrology data measured from one or more physical wafers), e.g., as obtained via computational lithography techniques which simulate one or more steps of a semiconductor manufacturing process.

Further embodiments of the invention are disclosed in the list of numbered clauses below:

1. A method for predicting a parameter of interest of a manufacturing process for manufacturing integrated circuits, the method comprising:obtaining metrology data relating to the parameter of interest; applying a first prediction sub-module to said metrology data to obtain non-anomalous prediction data; detecting anomalies in said metrology data; dividing said anomalies into systematic anomalies and non-systematic anomalies; using a first prediction strategy on said non-systematic anomalies to obtain first anomaly prediction data; using a second prediction strategy on said systematic anomalies to obtain second anomaly prediction data; wherein said first prediction strategy is different to said second prediction strategy; and combining said first anomaly prediction data and/or second anomaly prediction data with said non-anomalous prediction data to obtain a prediction of the parameter of interest.

2. A method according to clause 1, wherein said first prediction sub-module comprises a machine learning model or neural network trained to predict said parameter of interest based on said metrology data.

3. A method according to clause 1 or 2, wherein said metrology data comprises current metrology data and historic metrology data.

4. A method according to clause 3, comprising performing said detecting step on both of said current metrology data and historic metrology data prior to any processing of said metrology data in accordance with said first prediction strategy.

5. A method according to any preceding clause, wherein the steps of detecting anomalies in said metrology data and dividing said anomalies comprises detecting and dividing said anomalies comprised within at least said current metrology data.

6. A method according to any preceding clause, wherein said first prediction strategy comprises processing said metrology data corresponding to said non-systematic anomalies to obtained processed metrology data for which said non-systematic anomalies are smoothed, reduced or removed.

7. A method according to clause 6, comprising applying a smoothing filter smoothing to said metrology data corresponding to said non-systematic anomalies to obtain said processed metrology data.

8. A method according to clause 6 or 7, wherein said first prediction strategy comprises inputting said processed metrology data into said first prediction sub-module in place of the metrology data obtained in said obtaining step, to obtain said first anomaly prediction data.

9. A method according to any preceding clause, wherein said second prediction strategy comprises applying a second prediction sub-module to only a respective subset of metrology data immediately following each said systematic anomaly.

10. A method according to clause 9, wherein each said subset relates to a set time duration following each said systematic anomaly.

11. A method according to clause 10, wherein said second prediction strategy is applied only for said set time duration such that said second prediction sub-module is used in place of said first prediction sub-module for said set time duration.

12. A method according to clause 10 or 11, wherein a number of periods of said set time duration is determined empirically.

13. A method according to any of clauses 9 to 12, wherein said second prediction sub-module comprises a low pass temporal filtering module and/or a moving average based prediction sub-module.

14. A method according to clause 13, wherein said second prediction sub-module comprises an Exponentially Weighted Moving Average based prediction sub-module.

15. A method according to clause 13, wherein said second prediction sub-module comprises neural network trained to predict said parameter of interest based on said subset of metrology data.

16. A method according to any preceding clause, comprising retraining said first prediction sub-module using newly arriving said metrology data while applying said second prediction strategy.

17. A method according to any preceding clause, comprising identifying a systematic anomaly as an abrupt change in said metrology data occurring simultaneously in a plurality of time series of said metrology data.

18. A method according to any preceding clause, comprising identifying a non-systematic anomaly as an abrupt change in said metrology data not occurring simultaneously in a plurality of time series of said metrology data.

19. A method according to any preceding clause, comprising identifying as systematic anomalies, detected anomalies for which multiple elements of a single observation within said metrology data at a specific time point are anomalous; and identifying all other detected anomalies as non-systematic anomalies.

20. A method according to any preceding clause, wherein said step of detecting anomalies in said metrology data is performed using an adversarial machine learning model.

21. A method according to clause 20, wherein said adversarial machine learning model comprises a generative adversarial network based machine learning model.

22. A method according to clause 20, wherein said adversarial machine learning model comprises a cycle generative adversarial network based machine learning model.

23. A method according to clause 20, wherein said adversarial machine learning model comprises a cycle-consistent Wasserstein generative adversarial network with gradient penalty.

24. A method according to any of clauses 20 to 23, wherein said adversarial machine learning model comprises a first mapping function operable to map from a metrology data domain to a latent domain and a second mapping function operable to map from the latent domain to the metrology data domain, a first critic operable to encourage the first mapping function to translate a noise representation to data indistinguishable from said metrology data and a second critic operable to evaluate performance of mapping to said latent domain.

25. A method according to clause 24, wherein an anomaly is detected based on a critic score related to said first critic and/or a reconstruction error score of the adversarial machine learning model.

26. A method according to any of clauses 20 to 25, comprising continuously training said adversarial machine learning model via an automatic hyper-parameter optimization of the adversarial machine learning model.

27. A method according to any preceding clause, comprising continuously training said first prediction sub-module via an automatic hyper-parameter optimization of the first prediction sub-module.

28. A method according to clause 26 or 27, wherein said hyper-parameter optimization comprises a Bayesian optimization.

29. A method according to any of clauses 26 to 28, wherein said hyper-parameter optimization employs a gap and stride strategy wherein the stride determines the number of time points between two consecutive training steps and the gap determines the number of time points between the start and end of the hyper-parameter optimization.

30. A method according to any of clauses 26 to 29, wherein said automatic hyper-parameter optimization comprises routinely performing iterations of: a hyper-parameter optimization based on all metrology data obtained to obtain an optimized set of hyper-parameters; and a model retraining based on the latest optimized set of hyper-parameters.

31. A method according to any preceding clause, wherein said metrology data comprises one or more of: simulated metrology data; pre-exposure metrology data; post-exposure metrology data; and/or context data.

32. A method according to any preceding clause, comprising determining a correction for the manufacturing process from said prediction of the parameter of interest.

33. A method according to clause 32, wherein said determining a correction comprises determining a correction spatial distribution for a subsequent substrate or lot of substrates.

34. A method according to clause 32 or 33, wherein said determining a correction comprises determining a correction for a setting of an apparatus used in said manufacturing process.

35. A method according to any of clauses 32 to 34, comprising manufacturing further integrated circuits using said correction.

36. A method according to any preceding clause, comprising routinely measuring substrates to obtain said metrology data.

37. A computer program comprising program instructions operable to perform the method of any of clauses 1 to 35, when run on a suitable apparatus.

38. A non-transient computer program carrier comprising the computer program of clause 37.

39. A processing system comprising a processor and a storage device comprising the computer program of clause 37.

40. A lithographic apparatus arrangement comprising: a lithographic exposure apparatus; and the processing system of clause 39.

41. A lithographic cell comprising: the lithographic apparatus arrangement of clause 40; and a metrology device comprising the processing system of clause 39 and further operable to perform the method of clause 36.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for predicting a parameter of interest of a manufacturing process for manufacturing integrated circuits, the method comprising:

   obtaining metrology data relating to the parameter of interest;
   applying a first prediction sub-module to said metrology data to obtain non-anomalous prediction data;
   detecting anomalies in said metrology data;
   dividing said anomalies into systematic anomalies and non-systematic anomalies;
   using a first prediction strategy on said non-systematic anomalies to obtain first anomaly prediction data;
   using a second prediction strategy on said systematic anomalies to obtain second anomaly prediction data; wherein said first prediction strategy is different to said second prediction strategy; and

combining said first anomaly prediction data and/or second anomaly prediction data with said non-anomalous prediction data to obtain a prediction of the parameter of interest.

2. A method as claimed in claim 1, wherein said first prediction sub-module comprises a machine learning model or neural network trained to predict said parameter of interest based on said metrology data.

3. A method as claimed in claim 1 or 2, wherein said metrology data comprises current metrology data and historic metrology data.

4. A method as claimed in claim 3, comprising performing said detecting step on both of said current metrology data and historic metrology data prior to any processing of said metrology data in accordance with said first prediction strategy.

5. A method as claimed in any preceding claim, wherein said first prediction strategy comprises processing said metrology data corresponding to said non-systematic anomalies to obtained processed metrology data for which said non-systematic anomalies are smoothed, reduced or removed.

6. A method as claimed in claim 5, comprising applying a smoothing filter smoothing to said metrology data corresponding to said non-systematic anomalies to obtain said processed metrology data.

7. A method as claimed in claim 5 or 6, wherein said first prediction strategy comprises inputting said processed metrology data into said first prediction sub-module in place of the metrology data obtained in said obtaining step, to obtain said first anomaly prediction data.

8. A method as claimed in any preceding claim, wherein said second prediction strategy comprises applying a second prediction sub-module to only a respective subset of metrology data immediately following each said systematic anomaly.

9. A method as claimed in claim 8, wherein each said subset relates to a set time duration following each said systematic anomaly.

10. A method as claimed in claim 9, wherein said second prediction strategy is applied only for said set time duration such that said second prediction sub-module is used in place of said first prediction sub-module for said set time duration.

11. A method as claimed in any of claims 8 to 10, wherein said second prediction sub-module comprises a low pass temporal filtering module and/or a moving average based prediction sub-module.

12. A method as claimed in any preceding claim, comprising identifying a systematic anomaly as an abrupt change in said metrology data occurring simultaneously in a plurality of time series of said metrology data; and identifying a non-systematic anomaly as an abrupt change in said metrology data not occurring simultaneously in a plurality of time series of said metrology data.

13. A method as claimed in any preceding claim, comprising identifying as systematic anomalies, detected anomalies for which multiple elements of a single observation within said metrology data at a specific time point are anomalous; and identifying all other detected anomalies as non-systematic anomalies.

14. A method as claimed in any preceding claim, wherein said step of detecting anomalies in said metrology data is performed using an adversarial machine learning model, such as for example a generative adversarial network based machine learning model.

15. A method as claimed in claim 14, wherein said adversarial machine learning model comprises a first mapping function operable to map from a metrology data domain to a latent domain and a second mapping function operable to map from the latent domain to the metrology data domain, a first critic operable to encourage the first mapping function to translate a noise representation to data indistinguishable from said metrology data and a second critic operable to evaluate performance of mapping to said latent domain.

Fig. 1

Fig. 2

Fig. 3

(a)

(b)

Fig. 4

Fig. 5

Fig. 6

Fig. 7

Fig. 8

$$\hat{x} = F_{DEC}(G_{ENC}(x))$$

$$z \sim P_z \quad F_{DEC} \quad \tilde{x} = F_{DEC}(z)$$

$$C_X$$

$$C_Z$$

$$\hat{z} = G_{ENC}(x) \quad G_{ENC} \quad x \sim P_x$$

Fig. 9

Fig. 10

EP 4 357 854 A1

**EUROPEAN SEARCH REPORT**

Application Number

EP 22 20 2732

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "METHOD OF DETERMINING A CORRECTION FOR AT LEAST ONE CONTROL PARAMETER IN A SEMICONDUCTOR MANUFACTURING PROCESS", RESEARCH DISCLOSURE, KENNETH MASON PUBLICATIONS, HAMPSHIRE, UK, GB , vol. 688, no. 28 1 August 2021 (2021-08-01), XP007149562, ISSN: 0374-4353 Retrieved from the Internet: URL:ftp://ftppddoc/RDData688_EPO.zip Pdf/688028.pdf [retrieved on 2021-07-13] * paragraphs [0040] – [0069]; figures 5-10 * ----- | 1-15 | INV. G03F7/20 G03F9/00 H01L21/66 |
| A | SCHMITT-WEAVER EMIL ET AL: "Overlay improvements using a real time machine learning algorithm", PROCEEDINGS OF SPIE, IEEE, US, vol. 9050, 2 April 2014 (2014-04-02), pages 90501S-90501S, XP060030988, DOI: 10.1117/12.2046914 ISBN: 978-1-62841-730-2 * the whole document * ----- | 1-15 | TECHNICAL FIELDS SEARCHED (IPC) G03F H01L |
| A | SONG GILWOO ET AL: "Reduction in on-product overlay random error using machine learning algorithm", PROCEEDINGS OF THE SPIE, SPIE, US, vol. 12053, 26 May 2022 (2022-05-26), pages 120531O-120531O, XP060160696, ISSN: 0277-786X, DOI: 10.1117/12.2612771 * the whole document * ----- | 1-15 | |

The present search report has been drawn up for all claims

| Place of search | Date of completion of the search | Examiner |
|---|---|---|
| Munich | 5 April 2023 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- US 5229872 A
- US 6952253 B
- US 20100214550 A
- US 20070085991 A
- WO 2011081645 A
- US 20060016561 A
- US 20120008127 A
- US 20210405544 A1

**Non-patent literature cited in the description**

- **R.GOOD ; K CHAMNESS.** Small-Sample Controller State Estimation: Initializing the EWMA Filter. *AEC/APC Europe,* 20 April 2007
- TadGAN: Time series anomaly detection using generative adversarial networks. **ALEXANDER GEIGER et al.** 2020 IEEE International Conference on Big Data (Big Data). IEEE, 2020, 33-43